# EUROPEAN PATENT APPLICATION

(11) **EP 4 440 262 A1**
(43) Date of publication of application: **02.10.2024**
(21) Application number: 23218649.4
(22) Date of filing: 20.12.2023
(51) Int. Cl.: H05K 7/14, H05K 7/20

(54) **MOTOR CONTROLLER, AND ELECTRIC MOTOR AND VEHICLE COMPRISING SAME**

(30) Priority: 31.03.2023 CN 202310355983
(71) Applicant: XPT EDS (Hefei) Co., Ltd., Hefei City, Anhui 230601 (CN)
(72) Inventor: LI, Wenyu, Hefei City, Anhui (CN); HUANG, Gang, Hefei City, Anhui (CN); LIU, Chaohua, Hefei City, Anhui (CN); HONG, Wenwu, Hefei City, Anhui (CN)
(74) Representative: Vossius & Partner Patentanwälte Rechtsanwälte mbB

(57) **Abstract**

The disclosure relates to the technical field of controllers, and in particular to a motor controller, and an electric motor and a vehicle comprising the motor controller, in order to solve the problems of complex assembly, large size and heavy weight of conventional motor controllers. To this end, the motor controller of the disclosure comprises a cooling carrier, and an input module assembly, a power module, an output module assembly and an integrated circuit board that are electrically connected and mounted on the cooling carrier, wherein the input module assembly and the output module assembly are each separately integrated into one component, the integrated circuit board is a complete circuit board formed by integrating a control board and a drive board, the cooling carrier is provided with securing protrusion structures extending toward the integrated circuit board, and the integrated circuit board is directly securely connected to the securing protrusion structures. With such an arrangement, assembling steps of the motor controller can be simplified. By integrating a plurality of components into one component, the size and weight of the integrated component can be effectively reduced. By means of the securing protrusion structures, the NVH reducing effect of the integrated circuit board can be improved.

## Description

The present application claims priority of CN patent application 202310355983.X filed on March 31, 2023 with the title "Motor controller, and an electric motor and a vehicle comprising same".

### Technical Field

The disclosure relates to the technical field of controllers, and in particular to a motor controller, and an electric motor and a vehicle comprising the motor controller.

### Background Art

Current design forms of mainstream motor controllers have lasted for many years, and a complete industrial chain of each sub-component has been formed. Superficially, it is easy and cheap to purchase the components by means of the supply chain. However, due to lack of a deep understanding on the principles of an entire system and components thereof, it is very difficult to well achieve design breakthrough, and what we can only do is to simply assemble and connect separate components. Also, screw connection is an obsolete securing method. Although it is easy to purchase screwing devices, some screw locking problems have become bottlenecks in the industry and have not been solved.

The motor controllers of new energy vehicles available on the market are mounted one by one in separate housings through screws by means of a plurality of separate components and parts. This method has the defects of a large number of components and various types thereof, complex assembly, high risk of failure, large size and heavy weight, and is not in line with the development trend of new energy vehicles of a small size, light weight, high power density, high product quality and good stability.

Accordingly, there is a need for a new technical solution in the field to solve the problems mentioned above.

### Summary

It aims to solve at least one of the above-mentioned problems in the prior art, that is, to solve the problems of complex assembly, large size and heavy weight of conventional motor controllers.

In a first aspect, the disclosure provides a motor controller. The motor controller comprises a cooling carrier, and an input module assembly, a power module, an output module assembly and an integrated circuit board that are electrically connected and mounted on the cooling carrier; and the input module assembly, the power module and the output module assembly are located between the cooling carrier and the integrated circuit board, the input module assembly and the output module assembly are each separately integrated into one component, the integrated circuit board is a complete circuit board formed by integrating a control board and a drive board, the cooling carrier is provided with securing protrusion structures extending toward the integrated circuit board, and the integrated circuit board is directly securely connected to the securing protrusion structures.

Assembling steps of the motor controller can be greatly simplified by integrating the input module assembly into one component, integrating the output module assembly into one component, and further integrating the control board and the drive board into one complete integrated circuit board; and by integrating a plurality of components into one component, the size and the weight of the integrated component can also be effectively reduced. In addition, by providing, on the cooling carrier, the securing protrusion structures extending toward the integrated circuit board, the integrated circuit board is directly securely connected to the securing protrusion structures, so that a vibration transfer loop is reduced, a conduction path is shortened, and the NVH reducing effect of the integrated circuit board can be greatly improved.

In a preferred technical solution of the above-mentioned motor controller, the securing protrusion structures comprise a plurality of first securing protrusion structures and a plurality of second securing protrusion structures, where each of the first securing protrusion structures passes through the input module assembly and is then directly securely connected to the integrated circuit board, and the plurality of second securing protrusion structures are distributed around the power module and are directly securely connected to the integrated circuit board.

With such an arrangement, the NVH reducing effect of the integrated circuit board can be further improved.

In a preferred technical solution of the above-mentioned motor controller, at least one of the plurality of first securing protrusion structures passes through a supporting capacitor of the input module assembly and is then directly securely connected to the integrated circuit board.

With such an arrangement, the NVH reducing effect of the integrated circuit board can be further improved.

In a preferred technical solution of the above-mentioned motor controller, the input module assembly comprises a first housing, and a supporting capacitor, a filter assembly, a first input copper bar, a second input copper bar, high-voltage power supply wiring harnesses and a shielding plate that are integrated in the first housing, where the first housing is securely connected to the cooling carrier, a first end of the first input copper bar and a first end of the second input copper bar both extend out of the first housing and are respectively used to be electrically connected to a negative electrode and a positive electrode of a battery pack, and a second end of the first input copper bar and a second end of the second input copper bar both pass through the filter assembly and are then electrically connected to the supporting capacitor; and the supporting capacitor is electrically connected to one end of the power module, the high-voltage power supply wiring harnesses are configured to electrically connect the integrated circuit board to the second end of the first input copper bar and the second end of the second input copper bar, and the shielding plate is securely connected to the first housing and located on a side of the first housing away from the cooling carrier.

In a preferred technical solution of the above-mentioned motor controller, the filter assembly comprises a first capacitor bank, a magnetic filter core and a second capacitor bank that are provided in sequence, where the first capacitor bank comprises two first Y capacitors and an X capacitor located between the two first Y capacitors, the second capacitor bank comprises two second Y capacitors, the magnetic filter core is provided with a first through hole and a second through hole, and the second end of the first input copper bar and the second end of the second input copper bar respectively pass through the first through hole and the second through hole.

With such an arrangement, the filter assembly has better effects of filtering out higher harmonic waves and preventing crosstalk.

In a preferred technical solution of the above-mentioned motor controller, the supporting capacitor is provided with a plurality of first connection copper bars on a side thereof close to the power module, the first connection copper bar comprises a first terminal and two second terminals respectively located on two sides of the first terminal, the power module is provided with a plurality of second connection copper bars on a side thereof close to the supporting capacitor, and the second connection copper bar comprises a third terminal and two fourth terminals respectively located on two sides of the third terminal; and each first terminal is electrically connected to the corresponding third terminal, each second terminal is electrically connected to the corresponding fourth terminal, and the first terminal has the same polarity as the third terminal, but has a polarity different from those of the second terminal and the fourth terminal.

With such an arrangement, the equivalent series inductance in a circuit is smaller.

In a preferred technical solution of the above-mentioned motor controller, the input module assembly further comprises four grounding copper bars, where one end of each of two grounding copper bars of the four grounding copper bars is electrically connected to the corresponding first Y capacitor, one end of each of the other two grounding copper bars of the four grounding copper bars is electrically connected to the corresponding second Y capacitor, and the other end of each of the four grounding copper bars is electrically connected to the cooling carrier.

With such an arrangement, impedance and loss can be reduced.

In a preferred technical solution of the above-mentioned motor controller, the output module assembly comprises a second housing, and three alternating-current output copper bars and three current sensors that are integrated in the second housing, where the second housing is securely connected to the cooling carrier, first ends of the alternating-current output copper bars extend out of the second housing to be electrically connected to the other end of the power module, and the three current sensors are respectively configured to detect the current of the corresponding alternating-current output copper bars.

In a second aspect, the disclosure further provides an electric motor, the electric motor comprising a motor controller in the above-mentioned technical solution.

In a third aspect, the disclosure further provides a vehicle, the vehicle comprising a motor controller in the above-mentioned technical solution.

### Brief Description of the Drawings

A motor controller of the disclosure will be described below with reference to the accompanying drawings. In the drawings:
FIG. 1 is a first schematic perspective structural diagram of a motor controller of the disclosure;
FIG. 2 is a top view of a motor controller of the disclosure (with an integrated circuit board and a shielding plate not shown);
FIG. 3 is a cross-sectional view taken through A-A of FIG. 2;
FIG. 4 is a schematic structural diagram of a cooling carrier of a motor controller of the disclosure;
FIG. 5 is a first schematic perspective structural diagram of an input module assembly of a motor controller of the disclosure;
FIG. 6 is a second schematic perspective structural diagram of an input module assembly of a motor controller of the disclosure;
FIG. 7 is a schematic perspective structural diagram of a power module of a motor controller of the disclosure; and
FIG. 8 is a schematic perspective structural diagram of an output module assembly of a motor controller of the disclosure.

### List of reference numerals

10 - Cooling carrier; 101 - First securing protrusion structure; 102 - Second securing protrusion structure; 103 - Water-cooling plate; 104 - Water nozzle;
20 - Input module assembly; 201 - First housing; 202 - Supporting capacitor; 203 - High-voltage power supply wiring harness; 204 - Filter assembly; 205 - First input copper bar; 206 - Second input copper bar; 207 - Shielding plate; 208 - Grounding copper bar;
2021 - First terminal; 2022 - Second terminal; 2023 - Capacitor core pack; 2024 - Through hole;
2041 - First Y capacitor; 2042 - Second Y capacitor; 2043 - X capacitor; 2044 - Magnetic filter core;
30 - Output module assembly; 301 - Second housing; 302 - Alternating-current output copper bar; 303 - Current sensor;
40 - Integrated circuit board;
50 - Power module; 501 - Third terminal; 502 - Fourth terminal; 503 - Third connection copper bar;
60 - Compressing cover.

### Detailed Description of Embodiments

Preferred implementations of the disclosure will be described below with reference to the accompanying drawings. Those skilled in the art should understand that these implementations are only used to explain the technical principles of the disclosure, and are not intended to limit the scope of protection of the disclosure. For example, although the following embodiments are described in conjunction with electric vehicles, the technical solution of the disclosure is also applicable to other types of vehicles, such as gasoline-electric hybrid vehicles, etc., and such corresponding application adjustments and changes, which do not depart from the principles of the disclosure, shall all fall within the scope of protection of the disclosure.

It should be noted that in the description of the disclosure, the terms such as "upper", "lower", "left", "right", "top" or "bottom" indicate directions or positional relationships shown in the drawings, which are only for convenience of description, rather than to indicate or imply that an apparatus or an element must have a specific orientation, or be constructed and operated in a specific orientation. Therefore, these terms cannot be interpreted as a limitation on the embodiments of the disclosure. In addition, the terms "first" and "second" are used for descriptive purposes only, and cannot be construed as indicating or implying relative importance.

In addition, it should also be noted that in the description of the disclosure, the terms "mount", "provide", "connected to each other" and "connection" should be interpreted in a broad sense unless explicitly defined and limited otherwise. For example, a connection may be a secured connection, a detachable connection or an integral connection; may be a mechanical connection or an electrical connection; or may be a direct connection, an indirect connection by means of an intermediary, or internal communication between two elements. Those skilled in the art can understand specific meanings of the above terms in the disclosure according to specific situations.

Specifically, an electric vehicle of the disclosure comprises a battery pack and an electric motor, and the electric motor comprises a motor controller.

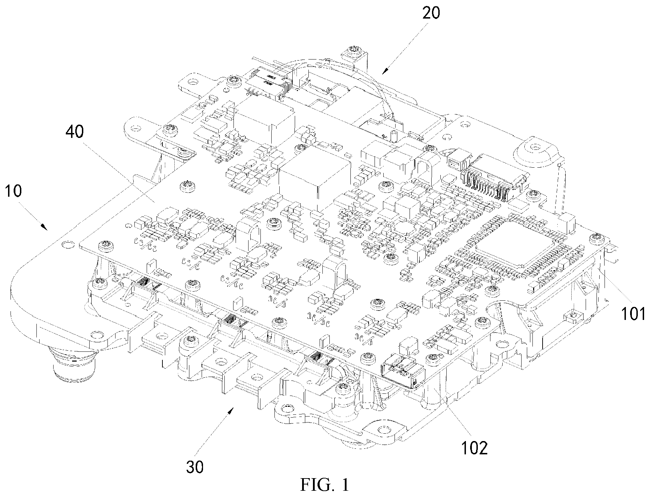

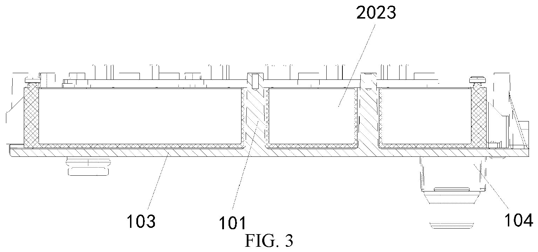

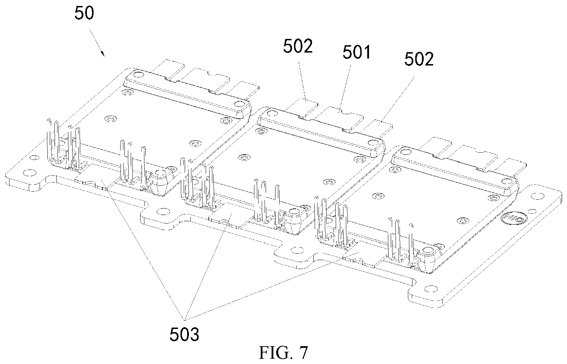

The motor controller of the disclosure will be described in detail below with reference to FIGS. 1 to 8.

As shown in FIGS. 1 to 8, the motor controller of the disclosure comprises a cooling carrier 10, an input module assembly 20, an output module assembly 30, an integrated circuit board 40 and a power module 50.

The input module assembly 20, the output module assembly 30, the integrated circuit board 40 and the power module 50 are all mounted on the cooling carrier 10, and the input module assembly 20, the output module assembly 30 and the power module 50 are located between the cooling carrier 10 and the integrated circuit board 40. Also, the power module 50 is located between the input module assembly 20 and the output module assembly 30, and two ends of the power module 50 are electrically connected to the input module assembly 20 and the output module assembly 30 respectively.

The input module assembly 20 and the output module assembly 30 are each integrated into one component, and the integrated circuit board 40 is a complete circuit board formed by integrating a control board and a drive board.

According to the disclosure, assembling steps of the motor controller can be greatly simplified by integrating the input module assembly 20 into one component, integrating the output module assembly 30 into one component, and further integrating the control board and the drive board into one complete integrated circuit board 40. In addition, by integrating a plurality of components into one component, the size and the weight of the integrated component can also be effectively reduced.

It should be noted that a control board and a drive board of a conventional motor controller are two independent circuit boards, and the two circuit boards are electrically connected by means of a high-voltage connection wiring harness. According to the disclosure, by integrating the control board and the drive board into one complete circuit board, that is, integrating all electrical components of a conventional control board and a conventional drive board onto one complete circuit board, one high-voltage connection wiring harness can be omitted, the area of the circuit board can also be reduced by about 10%, and accordingly the cost can be reduced by about 10%.

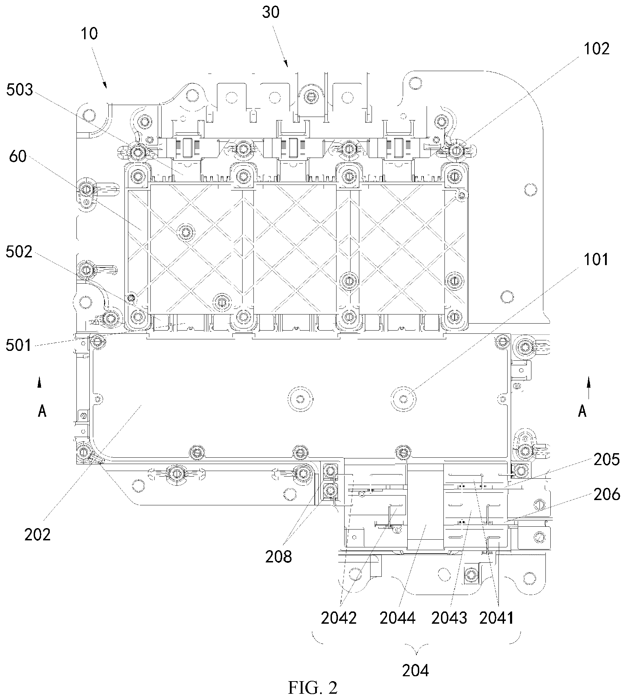

Preferably, as shown in FIGS. 2, 5 and 6, the input module assembly 20 of the disclosure comprises a first housing 201, and a supporting capacitor 202, high-voltage power supply wiring harnesses 203, a filter assembly 204, a first input copper bar 205, a second input copper bar 206 and a shielding plate 207 that are integrated in the first housing 201.

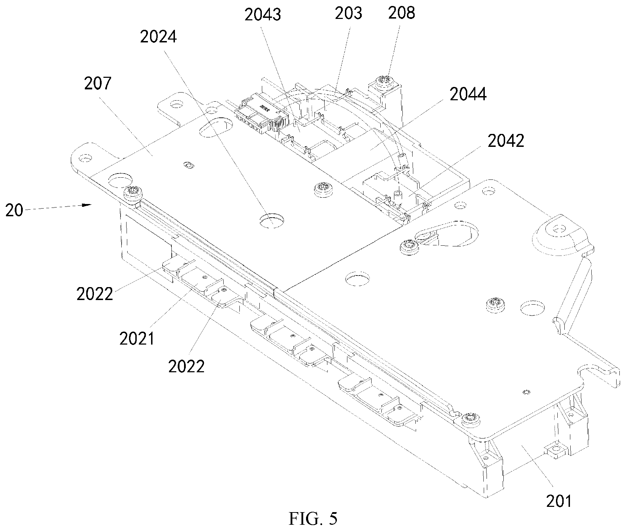

The first housing 201 is securely connected to the cooling carrier 10, a first end of the first input copper bar 205 (which is, viewed from FIG. 2, a right end of the first input copper bar 205) and a first end of the second input copper bar 206 (which is, viewed from FIG. 5, a right end of the second input copper bar 206) both extend out of the first housing 201 to be electrically connected to a negative electrode and a positive electrode of a battery pack respectively; and a second end of the first input copper bar 205 (which is, viewed from FIG. 2, a left end of the first input copper bar 205) and a second end of the second input copper bar 206 (which is, viewed from FIG. 2, a left end of the second input copper bar 206) respectively pass through the filter assembly 204 and are electrically connected to the supporting capacitor 202, and the supporting capacitor 202 is electrically connected to one end of the power module 50. The first housing 201 is preferably made of plastic.

The high-voltage power supply wiring harness 203 is configured to electrically connect the integrated circuit board 40 to the second end of the first input copper bar 205 and the second end of the second input copper bar 206. The number of the high-voltage power supply wiring harnesses 203 is two, one high-voltage power supply wiring harness is electrically connected to the second end of the first input copper bar 205, and the other high-voltage power supply wiring harness is electrically connected to the second end of the second input copper bar 206. The shielding plate 207 is securely connected to the first housing 201 and is located on a side of the first housing 201 away from the cooling carrier 10.

Illustratively, the bottom of the first housing 201 is securely connected to the cooling carrier 10 by means of screws, the shielding plate 207 is mounted on the top of the first housing 201, and the shielding plate 207 is capable of covering the supporting capacitor 202 in the first housing 201 to prevent electromagnetic waves released during operation of the supporting capacitor from affecting the integrated circuit board 40.

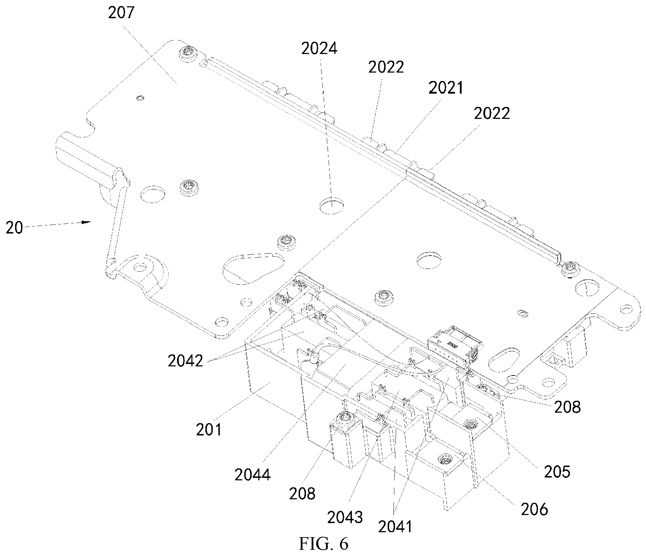

Preferably, as shown in FIGS. 2 and 6, the filter assembly 204 of the disclosure comprises a first capacitor bank, a magnetic filter core 2044 and a second capacitor bank that are provided in sequence, where the first capacitor bank comprises two first Y capacitors 2041 and an X capacitor 2043 located between the two first Y capacitors 2041, the second capacitor bank comprises two second Y capacitors 2042, the magnetic filter core 2044 is provided with a first through hole (not shown in the figures) and a second through hole (not shown in the figures), and the second end of the first input copper bar 205 and the second end of the second input copper bar 206 respectively pass through the first through hole and the second through hole.

According to the disclosure, by configuring the filter assembly 204 in the structural form of "capacitors (two Y capacitors + one X capacitor) + inductor + capacitors (two Y capacitors)", the filter assembly has better effects of filtering out higher harmonic waves and preventing crosstalk.

Illustratively, as shown in FIGS. 2 and 6, the first input copper bar 205 and the second input copper bar 206 are respectively located between the corresponding first Y capacitors 2041 and the X capacitor 2043, and the two second Y capacitors 2042 are respectively located between the first input copper bar 205 and the second input copper bar 206 and between the first input copper bar 205 and the supporting capacitor 202.

Preferably, as shown in FIGS. 2 and 6, the input module assembly 20 of the disclosure further comprises four grounding copper bars 208, where one end of each of two grounding copper bars 208 of the four grounding copper bars 208 is electrically connected to the corresponding first Y capacitor 2041, one end of each of the other two grounding copper bars 208 of the four grounding copper bars 208 is electrically connected to the corresponding second Y capacitor 2042, and the other end of each of the four grounding copper bars 208 is electrically connected to the cooling carrier 10.

Compared with the form in the prior art that only one grounding copper bar is provided, the disclosure can reduce impedance and loss by providing the four grounding copper bars.

Preferably, as shown in FIGS. 1 to 4, the disclosure is provided, on the cooling carrier 10, with securing protrusion structures extending toward the integrated circuit board 40, and the integrated circuit board 40 is directly securely connected to the securing protrusion structures.

Compared with the prior art in which the circuit board is secured to the shielding plate of the input module assembly 20, the disclosure is provided, on the cooling carrier 10, with the securing protrusion structures extending toward the integrated circuit board 40, and the integrated circuit board 40 is directly securely connected to the securing protrusion structures, so that the Noise, Vibration and Harshness (NVH) reducing effect of the integrated circuit board 40 can be greatly improved.

Illustratively, the cooling carrier 10 is located at the bottom, the integrated circuit board 40 is located at the top, and the input module assembly 20, the output module assembly 30 and the power module 50 are all located between the cooling carrier 10 and the integrated circuit board 40. During assembly, it is possible that the input module assembly 20, the output module assembly 30 and the power module 50 that are integrated are first secured to the cooling carrier 10 by means of screws respectively, and then the integrated circuit board 40 is securely connected to the securing protrusion structures on the cooling carrier 10 by means of screws.

It should be noted that in a practical application, those skilled in the art may provide the securing protrusion structures at an edge of the cooling carrier 10, or may provide the securing protrusion structures to be close to a middle area of the cooling carrier 10, such that the securing protrusion structures pass through the input module assembly 20 and are then securely connected to the integrated circuit board 40, etc. Such a flexible adjustment or change does not deviate from the principle and scope of protection of the disclosure, and should fall into the scope of protection of the disclosure.

Preferably, as shown in FIGS. 1 to 4, the securing protrusion structures comprise a plurality of first securing protrusion structures 101 and a plurality of second securing protrusion structures 102, the first securing protrusion structures 101 pass through the input module assembly 20 and are then directly securely connected to the integrated circuit board 40, and the plurality of second securing protrusion structures 102 are distributed around the power module 50 and are directly securely connected to the integrated circuit board 40.

Illustratively, as shown in FIGS. 1 to 4, the number of the first securing protrusion structures 101 is seven, the number of the second securing protrusion structures 102 is also seven, the seven second securing protrusion structures 102 are distributed around the power module 50, and a total of fourteen securing protrusion structures are provided on the cooling carrier 10 and are securely connected to the integrated circuit board 40.

Preferably, as shown in FIGS. 1 to 4, at least one of the plurality of first securing protrusion structures 101 passes through the supporting capacitor 202 of the input module assembly 20 and is then directly securely connected to the integrated circuit board 40.

Illustratively, as shown in FIGS. 1 to 5, the number of the first securing protrusion structures 101 is seven, two of the first securing protrusion structures 101 pass through the supporting capacitor 202 and are then securely connected to the integrated circuit board 40. Specifically, the supporting capacitor 202 comprises a plurality of capacitor core packs 2023, a through hole 2024 is arranged between two adjacent capacitor core packs 2023, and the corresponding first securing protrusion structure 101 extends out of the through hole 2024.

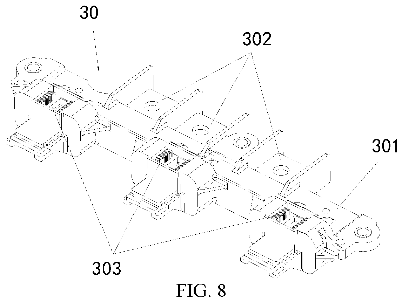

Preferably, as shown in FIG. 8, the output module assembly 30 of the disclosure comprises a second housing 301, and three alternating-current output copper bars 302 and three current sensors 303 that are integrated in the second housing 301.

First ends of the alternating-current output copper bars 302 extend out of the second housing 301 to be electrically connected to the power module 50, and the three current sensors 303 are respectively configured to detect the current of the corresponding alternating-current output copper bars 302. The second housing 301 is preferably made of plastic.

The power module 50 is capable of converting direct current into alternating current, and the supporting capacitor 202 of the input module assembly 20 and the alternating-current output copper bars 302 of the output module assembly 30 are electrically connected by means of the power module 50.

Specifically, as shown in FIG. 2 and FIGS. 5 to 8, the power module 50 is located between the supporting capacitor 202 and the alternating-current output copper bars 302, the supporting capacitor 202 is provided with a plurality of first connection copper bars (for example, three) on a side thereof close to the power module 50, the power module 50 is provided with a plurality of second connection copper bars (for example, three) on a side thereof close to the supporting capacitor 202, and the first connection copper bars are in one-to-one correspondence with the second connection copper bars and they are welded together, preferably by means of laser welding.

The first connection copper bar comprises a first terminal 2021 and two second terminals 2022 respectively located on two sides of the first terminal 2021. The second connection copper bar comprises a third terminal 501 and two fourth terminals 502 respectively located on two sides of the third terminal 501, where each first terminal 2021 is electrically connected to the corresponding third terminal 501, and each second terminal 2022 is electrically connected to the corresponding fourth terminal 502. The first terminal 2021 has the same polarity as the third terminal 501, but has a polarity different from those of the second terminal 2022 and the fourth terminal 502.

It is possible that the polarity of the first terminal 2021 is positive, and the polarities of the two second terminals 2022 on the two sides of the first terminal 2021 are negative; alternatively, it is also possible that the polarity of the first terminal 2021 is negative, and the polarities of the second terminals 2022 on the two sides of the first terminal 2021 are positive. Compared with a conventional design of one positive terminal and one negative terminal, the disclosure adopts a design of "negative terminal, positive terminal and negative terminal" or "positive terminal, negative terminal and positive terminal", such that the equivalent series inductance in a circuit is smaller.

Further, As shown in FIGS. 2, 7 and 8, the power module 50 is provided with three third connection copper bars 503 on a side thereof close to the alternating-current output copper bars 302, where the third connection copper bars 503 are in one-to-one correspondence with the alternating-current output copper bars 302 and they are welded together, also preferably by means of laser welding, and second ends of the alternating-current output copper bars 302 are connected to a three-phase copper bar of the electric motor. The alternating-current output copper bars 302 are capable of providing alternating sinusoidal current to the electric motor, ensuring that the electric motor rotates at a designated power in a designated direction, thereby propelling a vehicle to run.

As shown in FIG. 2, the power module 50 is sandwiched between a compressing cover 60 and the cooling carrier 10, and the compressing cover 60 and the cooling carrier 10 are securely connected by means of screws.

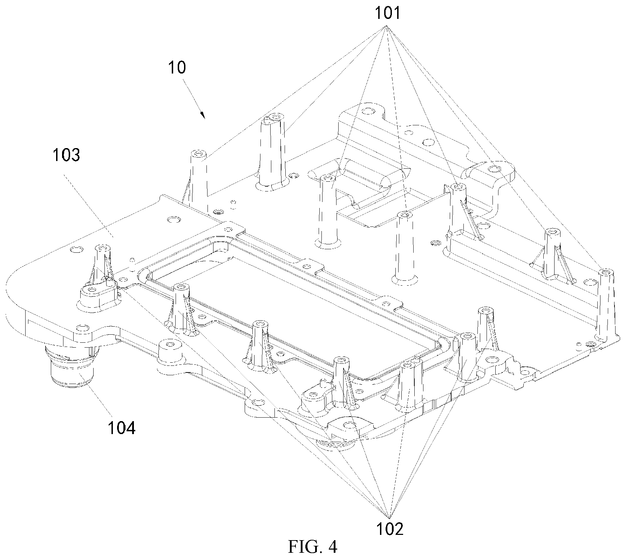

As shown in FIGS. 1 and 4, the cooling carrier 10 comprises a water-cooling plate 103 and a water nozzle 104 in communication with the water-cooling plate 103, such that it is possible to fill cooling water into the water-cooling plate 103 through the water nozzle 104. The input module assembly 20, the power module 50 and the output module assembly 30 are all securely connected to the water-cooling plate 103, and the first securing protrusion structures 101 and the second securing protrusion structures 102 are provided on the water-cooling plate 103.

It should be noted that those skilled in the art can understand that although some embodiments described herein comprise some but not other features comprised in other embodiments, combinations of features of different embodiments are meant to be within the scope of the disclosure and form different embodiments. For example, in the claims of the disclosure, any one of the claimed embodiments can be used in any combination.

Heretofore, the technical solutions of the disclosure have been described in combination with the preferred implementations shown in accompanying drawings. However, those skilled in the art can readily understand that the scope of protection of the disclosure is apparently not limited to these particular implementations. Those skilled in the art can make equivalent changes or substitutions to the related technical features without departing from the principle of the disclosure, and all the technical solutions with such changes or substitutions shall fall within the scope of protection of the disclosure.

## Claims

1. A motor controller, comprising a cooling carrier, and an input module assembly, a power module, an output module assembly and an integrated circuit board that are electrically connected and mounted on the cooling carrier, wherein the input module assembly, the power module and the output module assembly are located between the cooling carrier and the integrated circuit board, the input module assembly and the output module assembly are each separately integrated into one component, the integrated circuit board is a complete circuit board formed by integrating a control board and a drive board, the cooling carrier is provided with securing protrusion structures extending toward the integrated circuit board, and the integrated circuit board is directly securely connected to the securing protrusion structures.

2. The motor controller according to claim 1, wherein the securing protrusion structures comprise a plurality of first securing protrusion structures and a plurality of second securing protrusion structures, each of the first securing protrusion structures passes through the input module assembly and is then directly securely connected to the integrated circuit board, and the plurality of second securing protrusion structures are distributed around the power module and are directly securely connected to the integrated circuit board.

3. The motor controller according to claim 2, wherein at least one of the plurality of first securing protrusion structures passes through a supporting capacitor of the input module assembly and is then directly securely connected to the integrated circuit board.

4. The motor controller according to any one of claims 1 to 3, wherein the input module assembly comprises a first housing, and a supporting capacitor, a filter assembly, a first input copper bar, a second input copper bar, high-voltage power supply wiring harnesses and a shielding plate that are integrated in the first housing, wherein the first housing is securely connected to the cooling carrier, a first end of the first input copper bar and a first end of the second input copper bar both extend out of the first housing and are respectively used to be electrically connected to a negative electrode and a positive electrode of a battery pack, and a second end of the first input copper bar and a second end of the second input copper bar both pass through the filter assembly and are then electrically connected to the supporting capacitor; and the supporting capacitor is electrically connected to one end of the power module, the high-voltage power supply wiring harnesses are configured to electrically connect the integrated circuit board to the second end of the first input copper bar and the second end of the second input copper bar, and the shielding plate is securely connected to the first housing and located on a side of the first housing away from the cooling carrier.

5. The motor controller according to claim 4, wherein the filter assembly comprises a first capacitor bank, a magnetic filter core and a second capacitor bank that are provided in sequence, wherein the first capacitor bank comprises two first Y capacitors and an X capacitor located between the two first Y capacitors, the second capacitor bank comprises two second Y capacitors, the magnetic filter core is provided with a first through hole and a second through hole, and the second end of the first input copper bar and the second end of the second input copper bar respectively pass through the first through hole and the second through hole.

6. The motor controller according to claim 5, wherein the supporting capacitor is provided with a plurality of first connection copper bars on a side thereof close to the power module, the first connection copper bar comprises a first terminal and two second terminals respectively located on two sides of the first terminal, the power module is provided with a plurality of second connection copper bars on a side thereof close to the supporting capacitor, and the second connection copper bar comprises a third terminal and two fourth terminals respectively located on two sides of the third terminal; and each first terminal is electrically connected to the corresponding third terminal, each second terminal is electrically connected to the corresponding fourth terminal, and the first terminal has the same polarity as the third terminal, but has a polarity different from those of the second terminal and the fourth terminal.

7. The motor controller according to claim 5 or 6, wherein the input module assembly further comprises four grounding copper bars, wherein one end of each of two grounding copper bars of the four grounding copper bars is electrically connected to the corresponding first Y capacitor, one end of each of the other two grounding copper bars of the four grounding copper bars is electrically connected to the corresponding second Y capacitor, and the other end of each of the four grounding copper bars is electrically connected to the cooling carrier.

8. The motor controller according to any one of claims 1 to 7, wherein the output module assembly comprises a second housing, and three alternating-current output copper bars and three current sensors that are integrated in the second housing, wherein the second housing is securely connected to the cooling carrier, first ends of the alternating-current output copper bars extend out of the second housing to be electrically connected to the other end of the power module, and the three current sensors are respectively configured to detect the current of the corresponding alternating-current output copper bars.

9. An electric motor, comprising a motor controller according to any one of claims 1 to 8.

10. A vehicle, comprising a motor controller according to any one of claims 1 to 8.
